# DEMANDE DE BREVET EUROPEEN

(11) **EP 0 780 344 A2**
(43) Date de publication de la demande: **25.06.1997**
(21) Numéro de dépôt: 96402761.9
(22) Date de dépôt: 17.12.1996
(51) Int. Cl.: C03B 37/012, C03B 19/01, C30B 13/30

(54) **Procédé et installation de sustentation d'une masse liquide par une couche gazeuse**

(30) Priorité: 19.12.1995 FR 9515052
(71) Demandeur: COMMISSARIAT A L'ENERGIE ATOMIQUE, 75015 Paris Cédex 15 (FR)
(72) Inventeur: Kernevez, Nelly, 38700 Corenc (FR); Granier, Jean, 38100 Grenoble (FR); Daniel, Michel, 38410 St Martin D'Uriage (FR)
(74) Mandataire: Dubois-Chabert, Guy

(57) **Abrégé**

Procédé et installation de confinement ou de sustentation de masses liquides, pour les mouler, les mettre en forme ou simplement les conserver dans des récipients qu'elles pourraient corroder. La paroi (11) du récipient est poreuse et on y établit une circulation de gaz vers la masse liquide (14) pour intercaler une couche gazeuse entre elle et la paroi (11). Selon l'invention, la couche gazeuse est à une pression statique élevée, de 2 bars ou plus, ce qu'on obtient en construisant une enceinte étanche autour de la cavité (12) de confinement.

La matière liquide peut être métallique, un cristal fondu, du verre ou un semi-conducteur.

## Description

L'invention a trait à un procédé et une installation de sustentation d'une masse liquide par une couche gazeuse.

On peut éprouver le besoin de maintenir un liquide dans un récipient tel qu'un moule sans lui permettre de toucher les parois de ce récipient. En effet, de nombreux liquides peuvent réagir avec le matériau du récipient et en particulier nombre d'alliages métalliques, de verres, de cristaux et de semiconducteurs. Le contact avec le récipient risque d'altérer la composition chimique du produit, ou l'état du produit obtenu après solidification ou nucléation lors de cette solidification.

On a donc imaginé d'employer divers moyens pour empêcher le contact entre le récipient et la masse liquide, mais les procédés dits de sustentation par couche gazeuse sont particulièrement convenables sous gravité terrestre et pour des liquides. Le récipient est alors pourvu d'une paroi poreuse à travers laquelle le gaz est injecté pour repousser le liquide puis s'écouler le long de la paroi.

Une application importante de ces procédés de sustentation, qui ont donc pour effet de confiner le liquide au centre du contenu du récipient, est décrite dans le brevet français n°89 09123 et concerne la fabrication en continu d'un lingot en forme de barreau : le liquide est versé dans la cavité de moulage, dont le fond est fait d'une soupape qu'on abaisse peu à peu à mesure que du liquide est ajouté, en laissant la partie inférieure du lingot se solidifier. On observe malheureusement qu'il est impossible de mouler des barreaux élancés, car la hauteur possible est limitée à environ quatre fois le diamètre dans les installations existantes : des instabilités excessives de forme apparaissent ensuite, qu'on peut observer sous forme d'ondulations du ménisque formé à la surface supérieure du barreau ; elles finissent par provoquer le contact de la masse liquide sur la paroi du récipient en vainquant la poussée du gaz.

L'invention provient de la volonté de remédier à cette insuffisance de hauteur de la masse liquide confinée, et elle provient de l'observation que la pression essentiellement dynamique fournie par l'écoulement du gaz entre la masse liquide et la paroi poreuse, vers les extrémités de la cavité, n'était pas suffisante et que l'application d'une pression statique absolue plus importante, d'au moins deux bars dans la cavité, donnait des résultats bien meilleurs.

L'installation caractéristique de l'invention est donc caractérisée en ce qu'une enceinte amont, partiellement délimitée par la paroi poreuse et dans laquelle le gaz est d'abord insufflé avant de traverser cette paroi pour soutenir le liquide, est complétée par une enceinte aval englobant la cavité de moulage ou de confinement du liquide afin que la pression puisse y atteindre la valeur souhaitée. Des moyens de réglage de pression sont ajoutés pour que la différence de pression entre l'enceinte et la cavité soit aussi maintenue à une valeur admissible (de 40 à 300 mbars) : on a en effet déjà constaté qu'une différence de pression trop importante favorisait les instabilités de forme de la masse liquide.

On va maintenant passer au commentaire des figures suivantes, annexées à titre illustratif et nullement limitatif, pour décrire plus concrètement l'invention :
- la figure 1 est une vue schématique des caractéristiques des installations de l'art antérieur,
- la figure 2 est une vue d'une installation selon l'invention,
- la figure 3 est un schéma du système d'alimentation en gaz,
- la figure 4 est un autre schéma du système d'alimentation en gaz, et
- la figure 5 expose des résultats expérimentaux.

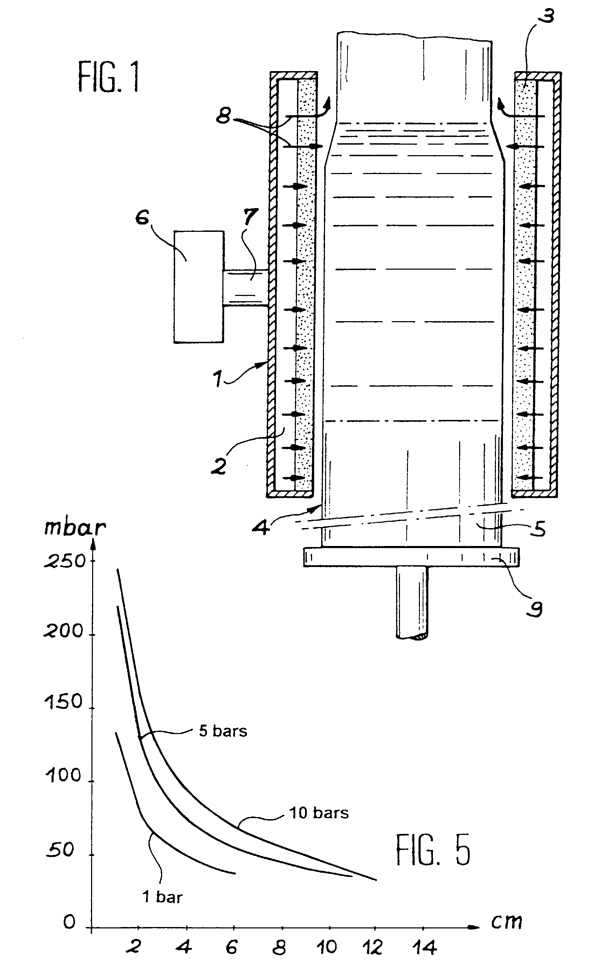

La figure 1 représente un moule 1 dont la paroi contient une enceinte 2 de forme annulaire et dont la face interne forme une paroi poreuse 3 également annulaire, qui entoure une cavité 4 dans laquelle un barreau 5 dont la partie moulée est liquide est contenu. Du gaz originaire d'une source 6 et d'un conduit 7 est insufflé dans l'enceinte 2, traverse la paroi poreuse 3, repousse d'elle le liquide du barreau 5 et s'écoule en formant une couche gazeuse 8 le long de la paroi poreuse 3 vers les extrémités de la cavité 4. Le barreau 5 est posé sur un plateau 9 qu'on abaisse à mesure que le liquide se solidifie. Un barreau à section régulière et toujours plus long est ainsi obtenu, mais, comme on l'a signalé, la hauteur de sa portion liquide ne peut pas dépasser environ quatre fois son diamètre.

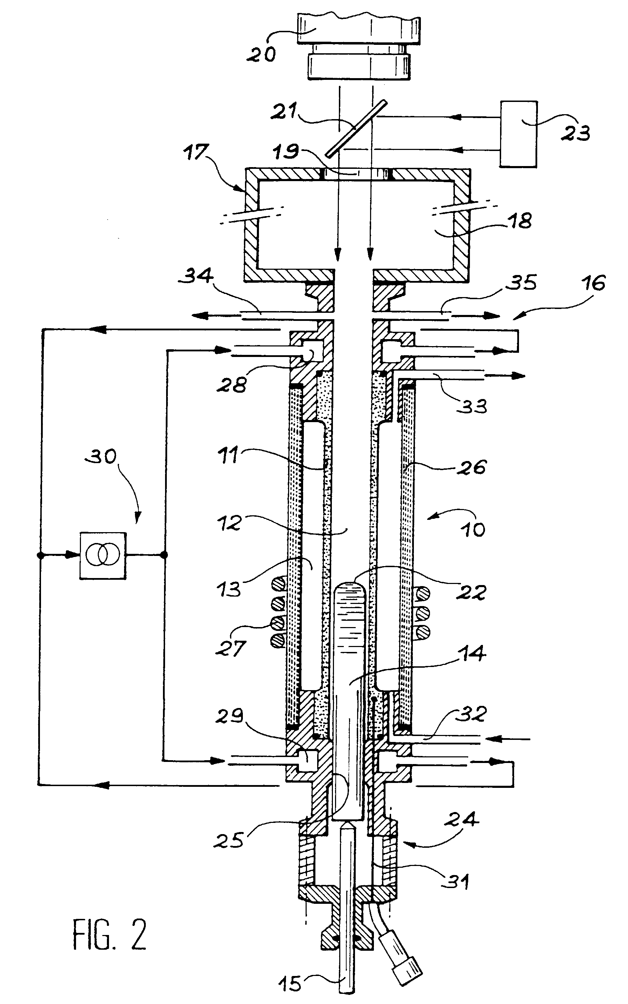

Un moule 10 conforme à l'invention, représenté à la figure 2, comprend en particulier une paroi poreuse 11 séparant une cavité 12 d'une enceinte amont 13 qui sont sensiblement semblables à celles de l'art antérieur ; un barreau 14, posé sur un support (ici un simple doigt coulissant 15), est encore moulé peu à peu. Mais la cavité 12 est fermée à ses deux extrémités : la paroi poreuse 11 se termine à son extrémité supérieure par un bouchon 16 sur le sommet duquel est fixée une boîte de liaison 17 close et qui permet éventuellement l'observation du processus de moulage au moyen d'instruments qui sont introduits dans la chambre 18 qu'elle forme. De plus, le sommet de la boîte de liaison 17, dans le prolongement de la cavité 12, est aménagé en hublot 19 au-delà duquel on trouve une caméra 20 de contrôle ; un miroir semi-réfléchissant 21 précède la caméra 20 et permet, par son orientation oblique, d'illuminer l'intérieur de la cavité 12 et le ménisque supérieur 22 du barreau 14 par le rayonnement d'une source lumineuse 23 réfléchi par le miroir 21 dans l'axe d'observation de la caméra 20, à travers la chambre 18, le bouchon supérieur 16 (qui est percé) et la cavité 12.

L'extrémité opposée de la paroi poreuse 11 est prolongée par un bouchon inférieur 24 pourvu d'un alésage 25 de guidage du barreau 14. La cavité 12 forme ainsi une enceinte aval isolée de l'extérieur.

L'enceinte amont 13 est délimitée principalement, outre la paroi poreuse 11, par un manchon en quartz 26 sertissant les bouchons 16 et 24. Des spires 27 de chauffage à haute fréquence l'encerclent à hauteur du sommet du barreau 14, pour le rendre ou le maintenir liquide à cet endroit. Les bouchons 16 et 24 sont refroidis par des canaux 28 et 29 qui s'étendent en eux et que parcourt du liquide de refroidissement originaire d'un circuit 30. Un thermocouple 31 s'étend à travers le bouchon inférieur 24 et son extrémité est logée dans le fond de la paroi poreuse 11 pour vérifier le bon déroulement du processus.

On trouve enfin plusieurs conduits destinés au passage du gaz, à savoir un conduit d'alimentation 32 qui débouche dans l'enceinte amont 13, un premier conduit de mesure 33 débouchant également dans l'enceinte amont 13, et enfin un conduit d'échappement 34 et un second conduit de mesure 35, tous deux traversant le bouchon supérieur 16 et communiquant à la cavité 12.

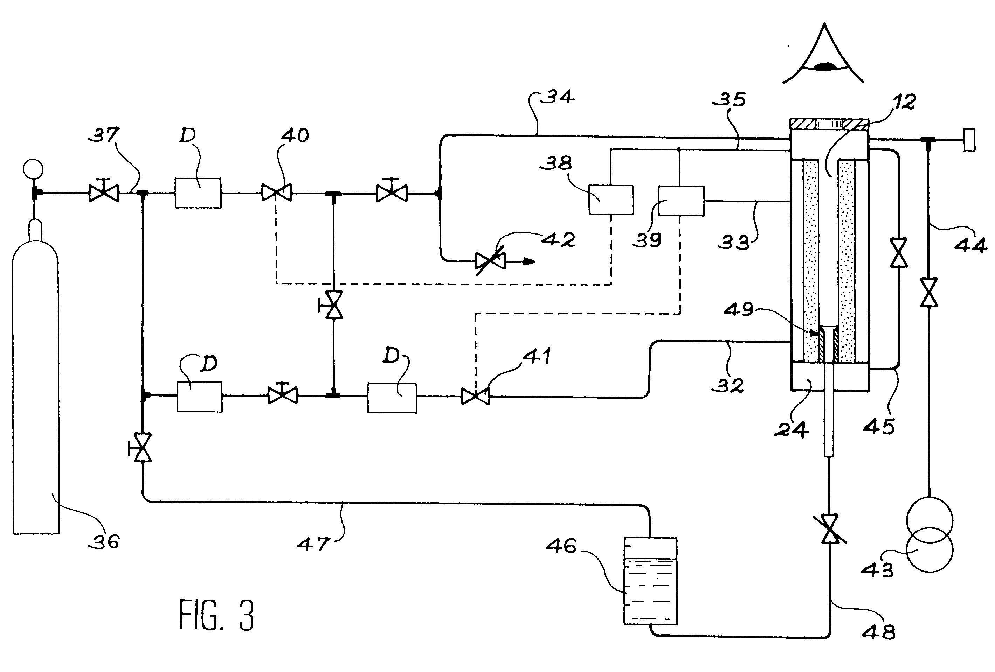

Ces conduits sont (en se reportant à la figure 3) reliés à une source de gaz sous pression, ici constituée par une bouteille 36 d'argon comprimé, sur le conduit de sortie 37 de laquelle se branche l'extrémité du conduit d'alimentation 32, alors que l'extrémité du conduit de sortie 37 aboutit au conduit d'échappement 34. Un manomètre de pression absolue 38 est branché au second conduit de mesure 35, alors qu'un manomètre de pression différentielle 39 est branché aux deux conduits de mesure 33 et 35 ; le manomètre absolu 38 commande une électrovanne 40 établie sur le conduit de sortie 37, en amont du conduit d'alimentation 32, pour régler l'alimentation en gaz, alors que le manomètre différentiel permet de commander une autre électrovanne 41, installée sur le conduit d'alimentation 32 et qui restreint l'accès à l'enceinte amont 13. Ainsi, l'électrovanne 40 permet de maintenir les deux enceintes en surpression par rapport à l'atmosphère, en imposant la valeur de la pression dans le conduit d'échappement 34 et l'enceinte aval, et l'autre électrovanne 41 permet de régler la surpression produite dans l'enceinte amont 13 par rapport à l'enceinte aval. Une vanne à fonctionnement manuel 42 est installée au bout du conduit d'échappement 34 pour y produire le débit d'échappement désiré. Ce débit, qui peut être trouvé expérimentalement, peut être vérifié en installant des débitmètres (portant la référence commune D) sur différentes parties du circuit de gaz. Des vannes (non référencées) peuvent aussi être installées sur les conduits pour les isoler ou, au contraire, mettre les enceintes en communication en cas de besoin ; la fermeture du circuit est en particulier souhaitée à une étape préliminaire du processus, où on établit le vide au moyen d'une pompe à vide 43 reliée par une conduite d'aspiration 44 à une des enceintes.

Une dérivation 45 peut être établie entre les extrémités de l'enceinte aval, des deux côtés du barreau 14, pour qu'une pression uniforme, le cas échéant, y règne ou encore pour provoquer une différence de pression si cela est nécessaire. Enfin, pour se ménager une possibilité de test un réservoir d'eau 46 est prévu pour que son contenu puisse être injecté dans la cavité 12, à la place du barreau 14 : l'eau permet de simuler la sustentation sans risque pour l'appareil, et la colonne qu'elle forme est donc observée pour s'assurer qu'elle reste stable et ne mouille pas la paroi poreuse 11. La viscosité de l'eau est plus faible que celle de la plupart des autres liquides, ce qui rend la sustentation de la colonne d'eau plus difficile et permet des évaluations prudentes de la qualité du processus. Une dérivation 47 du conduit de sortie 37 permet de souffler le gaz de la bouteille 36 dans le réservoir 46 pour l'évacuer, et une conduite 48 d'injection d'eau relie le réservoir 46 à la cavité 12. Ici comme ailleurs, des vannes sont prévues pour n'autoriser la communication qu'à volonté. La conduite 48 est engagée dans le bouchon inférieur 24, à la place du doigt 15, pendant cet essai préliminaire ; elle peut être terminée par une canule rigide 49 dont le diamètre correspond à celui de l'alésage 25. Lorsque aucun test n'est requis, la conduite 48 peut être retirée. Une vanne réglable manuellement 50 commande à la dérivation 47.

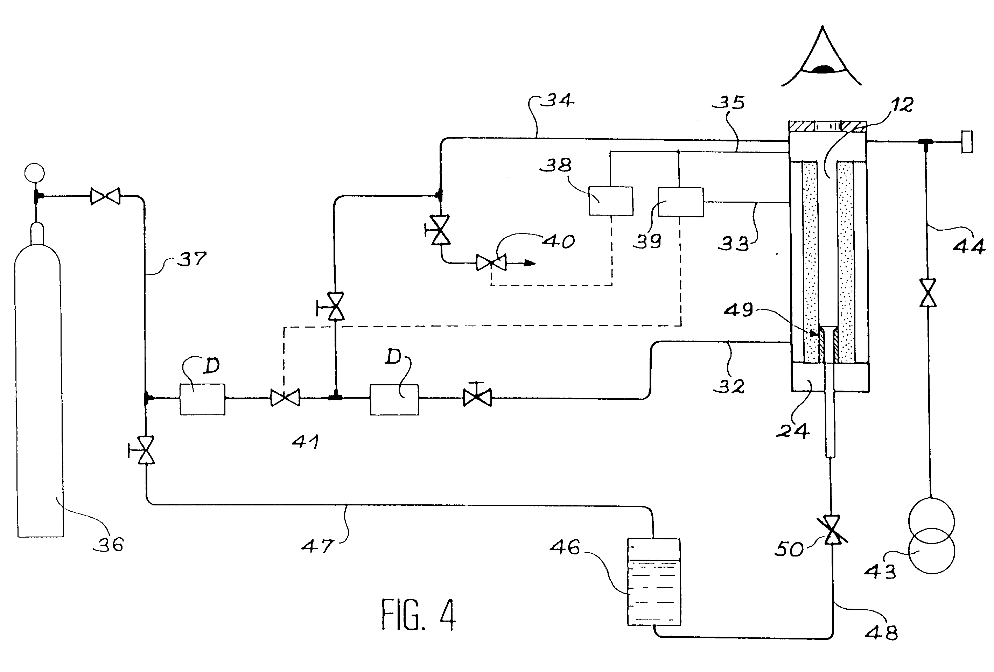

La figure 4 prouve que d'autres agencements convenables sont aussi possibles : la pression est ici commandée du côté de l'échappement, et c'est pourquoi l'électrovanne 40 du manomètre de pression absolue 38 est placée à l'extrémité du conduit d'échappement 34, et l'électrovanne 41 du manomètre de pression différentielle 39 est placée comme précédemment en amont de l'enceinte 13, sur le conduit d'alimentation 32. L'électrovanne 40 restreint le débit d'échappement d'air jusqu'à ce qu'une pression assez élevée soit obtenue dans les deux enceintes 12 et 13. Dans cette réalisation comme dans la précédente, des vannes manuelles sont prévues pour être ouvertes ou fermées à volonté, permettre le fonctionnement normal de l'installation ou servir dans des conditions exceptionnelles. Mais il est inutile que le conduit de sortie 37 débouche ici dans le conduit d'échappement 34.

On passe maintenant au commentaire de la figure 5. Il s'agit d'une série de courbes représentant, pour diverses valeurs de la pression dans la cavité 12, la hauteur de colonne d'eau qu'il est possible d'atteindre (en abscisses en centimètres), en fonction de l'écart de pression entre les deux enceintes (en ordonnées, en millibars). L'enseignement est double : tout d'abord et conformément à l'invention, la hauteur maximale qu'il est possible d'atteindre est bien supérieure avec des pressions de deux bars au moins, car elle est, notamment à partir de cinq bars, de près du double de celle qu'il est possible d'atteindre avec une pression d'un bar (c'est-à-dire à la pression atmosphérique, toutes les valeurs de pression données dans ce texte se rapportant à des pressions absolues) ; et, ce qui est connu en soi, que la hauteur maximale possible est atteinte pour des écarts de pression relativement faibles entre les enceintes, car une pression trop faible est impuissante à établir la sustentation et une différence excessive aggrave les perturbations dont la masse liquide est le siège ; on doit cependant remarquer que la valeur qu'il faut rechercher est à peu près la même dans tous les cas, de 40 ou 50 millibars environ, ce qui simplifie les réglages. Cette valeur peut être supérieure dans d'autres situations. En pratique, la différence de pression est établie à une valeur plus élevée au début, puis elle est peu à peu diminuée à mesure que la masse liquide est injectée, jusqu'à la valeur citée ci-dessus qui est choisie pour une phase de stabilité de la sustentation pendant laquelle le procédé de moulage se déroule.

L'invention peut être appliquée à des récipients, moules, creusets, etc., de toutes formes pour englober des masses liquides planes, hémisphériques, coniques, cylindriques, etc. ; on peut appliquer l'invention à des parois horizontales de fond de récipients pour soulever le liquide. La masse de liquide peut être aussi importante qu'une centaine de grammes.

On peut envisager d'employer l'invention pour la fabrication de fibres optiques ou de laser ou de verres à grande pureté, et/ou à bon état de surface et en général avec les matériaux mentionnés au début de ce texte. Parmi les différents essais, le verre de la composition suivante a pu être mis en forme avec cent fois moins de défauts que par un procédé classique : ZrF₄ : 54%, BaF₂ : 19%, LaF₃ : 4%, AlF₃ : 4% et NaF : 20%. Un autre exemple à mentionner concerne les verres en oxyde de silicate, borosilicate ou silico-calciques pour lesquels on a pu employer des concentrations élevées en CaO, interdites avec les techniques classiques : un exemple de composition est SiO₂ : 40% environ, CaO : 30%, LiO : 27,3%, Al₂O₃ : 2,5%, Nd₂O₃ : 0,5% et CO₂ : 0,16%.

La couche gazeuse de sustentation peut être épaisse de dix micromètres environ, et le gaz peut être de composition quelconque. En général inerte vis-à-vis du produit à traiter, ce gaz peut être choisi, selon le cas, réactif : l'affinage du verres fluorés nécessite, par exemple, la présence dans la phase gazeuse d'une certaine quantité de SF₆ ou de BF₃.

## Revendications

1. Procédé de sustentation d'une masse liquide (14) dans une cavité d'un récipient (10) par une couche de gaz soufflé à travers une paroi poreuse (13) du récipient, où une différence de pression du gaz de 40 à 300 millibars est instaurée à travers la paroi poreuse dans une phase de stabilité de la sustentation, caractérisé en ce que le gaz est à une pression d'au moins deux bars dans la cavité (12).

2. Installation de sustentation d'une masse liquide, comprenant une source de gaz sous pression (36), une enceinte amont (13) délimitée partiellement par une paroi poreuse (11) entourant une cavité (12) dans laquelle la masse liquide est contenue, caractérisée en ce qu'elle comprend une enceinte aval englobant la cavité (12), et en ce que la source de gaz communique aux deux enceintes par des moyens de réglage de pression comprenant au moins un moyen de réglage de différence de pression (39, 41) entre les enceintes.

3. Installation de sustentation d'une masse liquide selon la revendication 2, caractérisée en ce que les moyens de réglage de pression comprennent un conduit (37) de fourniture de gaz comprimé communiquant (34) à l'enceinte aval.

4. Installation de sustentation d'une masse liquide selon la revendication 3, caractérisée en ce que le conduit de fourniture de gaz communique à l'enceinte aval par un conduit d'échappement (34) de l'enceinte aval, et en ce qu'il comprend un embranchement (32) aboutissant à l'enceinte amont (13).

5. Installation de sustentation d'une masse gazeuse selon l'une quelconque des revendications 2 à 4, caractérisée en ce qu'elle comprend un manomètre de pression absolue (38) commandant à une électrovanne (40) chargée d'ajuster la pression dans les enceintes et un manomètre de différence de pression (39) commandant à une électrovanne (41) chargée d'ajuster la différence de pression entre les enceintes.
